(19) Europäisches Patentamt
European Patent Office
Office européen des brevets

(11) **EP 3 611 757 A1**

(12) **EUROPEAN PATENT APPLICATION**

(43) Date of publication:
**19.02.2020 Bulletin 2020/08**

(51) Int Cl.:
**H01L 21/265** (2006.01)  **H01L 21/268** (2006.01)

(21) Application number: **18189418.9**

(22) Date of filing: **16.08.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Laser Systems & Solutions of Europe 92230 Gennevilliers (FR)**

(72) Inventors:
• **TABATA, Toshiyuki**
  **92230 GENNEVILLIERS (FR)**

• **MAZZAMUTO, Fulvio**
  **92230 GENNEVILLIERS (FR)**

(74) Representative: **Jacobacci Coralis Harle
32, rue de l'Arcade
75008 Paris (FR)**

Remarks:
A request for correction of the drawings has been filed pursuant to Rule 139 EPC. A decision on the request will be taken during the proceedings before the Examining Division (Guidelines for Examination in the EPO, A-V, 3.).

(54) **METHOD FOR FORMING A DOPED REGION ON A SEMICONDUCTOR MATERIAL**

(57)    A method for forming a doped region (27) on a semiconductor material (3), comprising steps of:
- implanting a first dose of a first dopants (7) to form an implanted region (13) of the semiconductor material,
- implanting a second dose of a second dopants (9) to said implanted region,
- melting the implanted region with a nanosecond pulsed laser beam (23) to diffuse the first dose of first dopants and the second dose of second dopants into a molten implanted region (25),
- crystallizing the molten implanted region to form said doped region, having a first dopants concentration profile (37) with a first peak at a first material depth (D1), and a second dopants concentration profile (39) with a second peak at a second material depth (D2), wherein the first material depth is greater than the second material depth.

A corresponding semiconductor material and a semiconductor device are also described.

Fig.2

EP 3 611 757 A1

## Description

TECHNICAL FIELD OF THE INVENTION

The invention relates to the manufacturing of semiconductor materials.

More precisely the invention relates to a method for forming a doped region on a semiconductor material.

The invention also relates to a semiconductor material having a doped region.

The invention also relates to a semiconductor device comprising a semiconductor material.

BACKGROUND INFORMATION AND PRIOR ART

To improve the performance of small semiconductor devices, such as 20nm and below in the technology mode, it is primordial to minimize their access resistance.

The access resistance is due to a Schottky resistance at a metal/semiconductor interface of the device, and to a source/drain resistance given by the intrinsic resistance of an epi-grown source/drain semiconductor material. In other words, the Schottky resistance occurs at the surface of the epi-grown semiconductor material of the semiconductor device, whereas the source/drain resistance occurs in a deeper region of the epi-grown semiconductor material.

To improve the performance of semiconductor devices, it is common to introduce a dose (or amount) of impurities, known as dopant, in an epi-grown semiconductor material in order to decrease its electrical resistance. A higher dose will result in a higher active dopant concentration and hence to a lower resistance. However, the activation may not exceed the solubility limit of the dopant in the semiconductor material.

The semiconductor material is then annealed so the dose of dopants diffuses into the semiconductor material.

In the case of a conventional furnace annealing, the semiconductor material is not melted. Then, the dopants diffuse into the doped semiconductor material. This method will reduce the source/drain resistance, however, the dopants concentration achieved at the surface is not large enough to overcome the Schottky resistance.

In the case of a melt laser annealing, a shallow region at the surface of the semiconductor material is melted. After recrystallization, the dopants are concentrated towards the surface of the semiconductor material. This method will reduce Schottky resistance, but not the source/drain resistance.

A method for improving the semiconductor devices performance is desired.

SUMMARY OF THE INVENTION

In this context, the invention provides a method for forming a doped region in an epi-grown semiconductor material, comprising steps of:

b) implanting a first dose of a first dopants to form an implanted region of the semiconductor material,

c) implanting a second dose of a second dopants to said implanted region,

d) melting the implanted region with a nanosecond pulsed laser beam to diffuse the first dose of first dopants and the second dose of second dopants into the molten implanted region, and

e) crystallizing the molten implanted region to form said doped region, said doped region having a first dopants concentration profile with a first concentration peak at a first semiconductor material depth, and a second dopants concentration profile with a second concentration peak at a second semiconductor material depth, wherein the first semiconductor material depth is greater than the second semiconductor material depth.

The depth of each concentration peak is determined by the type of the dopants and during step e). Hence, thanks to the method of the invention, it is possible to form the second peak of concentration at a second depth close to the surface of the semiconductor material. The second concentration peak of second dopants is high enough to decrease the Schottky resistance.

The first peak of concentration is formed at a first depth greater than the second depth in order to reduce the source/drain resistance of the semiconductor material.

By forming a doped region with a plurality of successive concentration peaks at different depths, it is possible to obtain a high dopant concentration throughout the doped region and as a consequence, greatly increase the performance of the semiconductor device.

The semiconductor material with doped regions may be used to fabricate a diversity of semiconductor devices such as transistors or diodes.

Other advantageous and non-limiting features of the method according to the invention include:

- the first dopants have a first segregation coefficient and the second dopants have a second segregation coefficient,
- the method further comprises a step of selecting the first dopants and the second dopants according to their respective segregation coefficients,
- the second segregation coefficient is lower than the first segregation coefficient,
- during the step of crystallizing, a liquid/solid interface between a solid phase of the semiconductor material and a liquid phase of the molten implanted region moves towards the surface of the semiconductor surface at a velocity, and the velocity of the interface is controlled by a parameter relative to the nanosecond pulsed laser beam,
- the parameter relative to the nanosecond pulsed laser beam includes at least one among: a pulse shape, a pulse duration, a pulse energy density,
- the first dopants are implanted to extend to a first projection depth and the second dopants are implanted to extend to a second projection depth, and the first projection depth and the second projection depth are sensibly equal,
- the method further comprises a step of providing at least a third dose of a third dopant to the implanted region, the third dopant having a third segregation coefficient different from the first segregation coefficient and the second segregation coefficient.

The invention also relates to a semiconductor material having a doped region comprising a first dopants having a first dopant concentration profile with a first concentration peak at a first semiconductor material depth, and a second dopants, having a second dopant concentration profile with a second concentration peak at a second semiconductor material depth, wherein the first semiconductor material depth is greater than the second semiconductor material depth.

Other advantageous and non-limiting features of the semiconductor material having a doped region according to the invention include:

- a concentration of first dopants at the first concentration peak is comprised between $1 \times 10^{21}$ atoms/cm$^3$ and $1 \times 10^{23}$ atoms/cm$^3$.
- a concentration of second dopants at the second concentration peak is comprised between $1 \times 10^{21}$ atoms/cm$^3$ and $1 \times 10^{23}$ atoms/cm$^3$.
- the second semiconductor material depth is comprised between 0 and 10 nm, and the first semiconductor material depth is deeper than the second semiconductor material depth,
- the first dopants have a first segregation coefficient and the second dopants have a second segregation coefficient different from said first segregation coefficient,
- the semiconductor material having a doped region further comprises a third dopant having a third dopant concentration profile with a third concentration peak at a third semiconductor material depth, wherein the third semiconductor material depth is different from the first semiconductor material depth and from the second semiconductor material depth.

The invention also relates to a semiconductor device comprising a semiconductor material, having a metallic contact region situated on a surface of the doped region of the semiconductor material.

DETAILED DESCRIPTION OF EXAMPLE(S)

This description is given for non limiting illustrative purposes only and will be better understood when referring to the annexed drawings wherein:

- Figure 1 is a schematic representation of a system for forming a doped region in a semiconductor material,
- Figure 2 is a schematic sectional view of a semiconductor device comprising the semiconductor material with the doped region,
- Figure 3 is a schematic representation of the steps of the method according to the invention,
- Figures 4a to 4f are graphs of doping profiles of the semiconductor material before, during and after annealing,
- Figures 5a and 5b are graphs of doping profiles of the semiconductor material before and after annealing, based on experimental data,
- Figure 6 is a graph of the variation of a velocity of a liquid/solid interface in the semiconductor material in function of the melting depth.

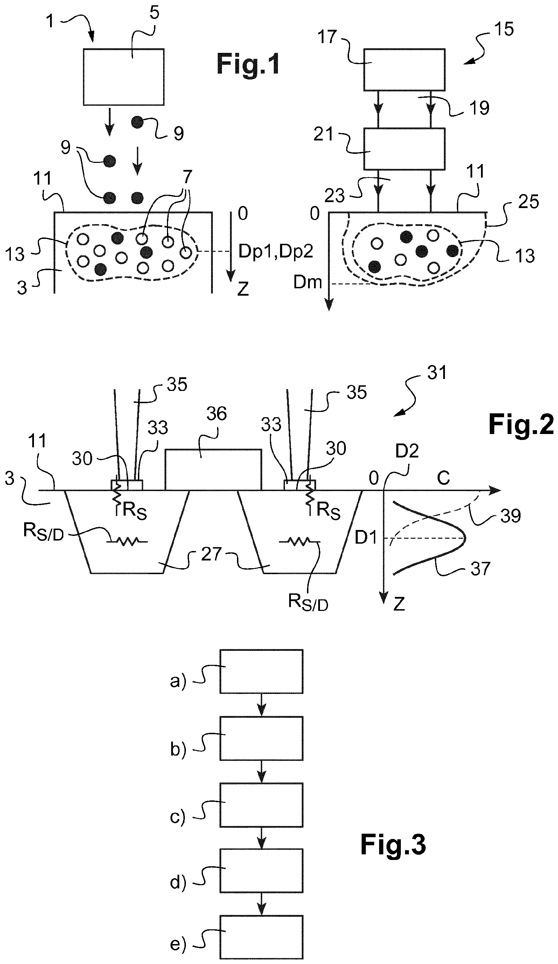

Figure 1 represents a system 1 for forming a doped region on a semiconductor material 3. The semiconductor material 3 is for example a SiGe (Silicon - Germanium) epi-grown layer, or substrate, or a Si (Silicon) epi-grown layer, or substrate, or a Ge (Germanium) epi-grown layer, or substrate.

System 1 comprises an implantation device 5 for introducing a dose of dopants into semiconductor material 3.

Here, implantation device 5 implants a first dose of first dopants 7 and a second dose of second dopants 9 into semiconductor material 3.

Implantation device 5 accelerates the first dose of first dopants 7 and the second dose of second dopants 9 from a respective ion source towards a face 11 of semiconductor material 3 to form an implanted region 13.

First dopants 7 penetrate semiconductor material 3 to a first projection depth Dp1. Second dopants 9 penetrate semiconductor material 3 to a second projection depth Dp2. First projection depth Dp1 and second projection depth Dp2 are the depths at which first dopants 7 and second dopants 9 respectively show a profile peak and are respectively located inside material 3 after implantation.

The projection depths Dp1, Dp2 are measured along a first axis (0z) perpendicular to face 11, whose origin 0 is situated on face 11 and oriented towards the bulk of semiconductor material 3. On Figure 1, and on the subsequent figures and graphs, the first axis (0z) represents the depth within semiconductor material 3, i.e. the depth.

First dopants 7 have a first segregation coefficient k1. Second dopants 9 have a second segregation k2. Second segregation k2 is different from first segregation coefficient k1.

The segregation coefficient k is the ratio of the concentration of a dopant in the semiconductor material in solid phase Csolid to the concentration of the dopant in the semiconductor material in liquid phase Cliquid. The segregation coefficient k is given by the formula:

$$k = \frac{C_{solid}}{C_{liquid}}$$

A segregation coefficient k close to 1 indicates that the dopants are uniformly distributed in the doped region of the semiconductor material once it has recrystallized.

A segregation coefficient k lower than 1 indicates that, the dopants are not uniformly distributed in the doped region of the semiconductor material once it has recrystallized. More precisely, dopants with segregation coefficient k << 1 tend to concentrate in the liquid phase of a melted semiconductor material.

Here, first dopants 7 comprise, for example, Boron atoms. Second dopants 9 are different from first dopants 7. Second dopants 9 comprise, for example, Gallium atoms. First segregation coefficient k1 and second segregation coefficient k2 are different. The first segregation coefficient k1 of Boron is greater than the second segregation coefficient k2 of Gallium. As a consequence, the atoms of Boron will distribute more uniformly than the atoms of Gallium.

Other examples of first dopants 7 and second dopants 9 include Indium (In), Aluminum (Al), Phosphorus (P) and Antimony (Sb).

Optionally, implantation device 5 further introduces at least a third dose of third dopants having a third segregation coefficient k3 different from first segregation coefficient k1 and second segregation coefficient k2. Examples of third dopants include Boron (B), Gallium (Ga), Indium (In), Aluminum (Al), Phosphorus (P) and Antimony (Sb).

System 1 also comprises an annealing device 15. Annealing device 15 comprises a light source 17 that emits a laser beam 19. Light source 17 is, for example, an ultraviolet excimer laser with an emitting wavelength of 308 nm. Light source 17 is, for example, a nanosecond pulsed laser source which emits a pulsed laser beam.

Annealing device 15 also comprises a beam control device 21 that receives and modifies emitted laser beam 19 to produce a nanosecond pulsed laser beam 23 adapted to melt implanted region 13.

Beam control device 21 controls the depth of melting and the extent of a molten region 25 of semiconductor material 3 by controlling parameters relative to nanosecond pulsed laser beam 23, such as a pulse shape, a pulse duration and a pulse energy density of nanosecond pulsed laser beam 23. To this end, beam control device 21 comprises components such as a cavity, lenses, mirrors, attenuators and masks.

For example, beam control device 21 controls the shape of nanosecond pulsed laser beam 23 by changing a gas pressure in the cavity, and/or by passing the emitted laser beam 19 through the mirrors having different reflectivity.

For example, beam control device 21 controls the pulse energy density by passing nanosecond pulsed laser beam 23 through the attenuator, comprising for example an attenuation plate, and by changing the transmission of the attenuator. Alternatively, or in addition, beam control device 21 controls the pulse energy density by changing a high voltage which triggers nanosecond pulsed laser beam 23 in the cavity.

Alternatively, light source 17 may be a continuous wave laser emitting a continuous laser beam, and beam control device 21 comprises components adapted to modify the continuous laser beam into nanosecond pulsed laser beam 23.

By controlling the parameters relative to nanosecond pulsed laser beam 23, beam control device 21 also controls the crystallization of molten region 25 and the formation of a doped region 27 (Figure 2) of semiconductor material 3.

Referring to Figure 2, a semiconductor device 31 comprises semiconductor material 3 with doped regions 27. Semiconductor device 31 is, here, a field effect transistor with two doped regions 27: a source region and a drain region. The doped regions 27 have a resistance, here a source/drain resistance $R_{S/D}$.

Alternatively, the semiconductor device may be another type of transistor such as a bipolar junction transistor. Alternatively, the semiconductor device may be a diode.

A metallic contact region 33 is situated on each of doped regions 27.

An electrode 35 is connected to each of the metallic contact regions 33.

The electrodes 35 provide the doped regions 27 with electrical current.

A gate 36 modulates a conductivity of a channel between the source region and the drain region.

A metal/semiconductor interface 30 between a doped region 27 and metallic contact region 33 has a Schottky resistance $R_S$.

Figure 2 also represents a graph of the variation of the concentration of the dopants 7, 9 in semiconductor material 3 as a function of the depth of semiconductor material 3. In other words, Figure 2 represents the dopant concentration profiles (or doping profiles) of each specie of dopants. The concentration of dopants is represented along a second axis (0c) and is expressed in atoms/cm$^3$ (at/cm$^3$ on the graphs).

First dopants 7 have a first dopant concentration profile 37 with a first concentration peak at a first depth D1. Second dopants 9 have a second dopant concentration profile 39 with a second concentration peak at a second depth D2.

As it is clearly represented, first depth D1 is greater than second depth D2. Second depth D2 is near the surface of semiconductor material 3, for example between 0 and 10 nm from the surface. First Depth D1 is, for example, comprised between 1nm and 20 nm.

A concentration of first dopants (C1) at the first concentration peak is, for example, comprised between

$1x10^{21}$ atoms/cm$^3$ and $1x10^{23}$ atoms/cm$^3$.

A concentration of second dopants (C2) at the second concentration peak is, for example, comprised between $1x10^{21}$ atoms/cm$^3$ and $1x10^{23}$ atoms/cm$^3$.

Referring to Figure 3, the method for forming a doped region 27 in a semiconductor material 3 comprises a step a) of selecting first dopants 7 and second dopants 9 according to their respective segregation coefficients k1, k2. The segregation coefficients k1, k2 are selected such that one segregation coefficient, here first coefficient k1, is greater than the other segregation coefficient, here second segregation coefficient k2.

First dopants 7, here Boron atoms, have a first segregation coefficient k1 comprised between 0.65 and 0.75 in thermodynamic equilibrium in a Silicon material.

Second dopants 9, here Gallium atoms, have a second segregation coefficient k2 comprised between 0.008 and 0.012 in thermodynamic equilibrium in a Silicon material.

Then, during a step b), implantation device 5 implants the first dose of first dopants 7 to form implanted region 13 of the semiconductor material 3. The first dose is selected so that first dopants 7 do not exceed their solubility limit in the liquid phase of the semiconductor material 3.

The first dose of first dopants 7 is implanted to extend to first projection depth Dp1. First projection depth Dp1 is determined by the energy used to accelerate first dopants 7 towards semiconductor material 3.

Then, during a step c), implantation device 5 implants the second dose of second dopants 9 into implanted region 13.

The second dose is selected so that second dopants 9 do not exceed their solubility limit in the liquid phase of the semiconductor material 3.

The second dose of second dopants 9 is implanted to extend to the second projection depth Dp2. Second projection depth Dp2 is determined by the energy used to accelerate second dopants 9 towards semiconductor material 3.

First projection depth Dp1 and second projection depth Dp2 may be sensibly equal, for example 10 nm. Alternatively, first projection depth Dp1 and second projection depth Dp2 may be different.

Step c) may be performed before step b). In this case, the implantation of the second dose of second dopants 9 forms implanted region 13, and the first dose of first dopants 7 is implanted into implanted region 13. In other words, first dopants 7 and second dopants 9 may be implanted in any order.

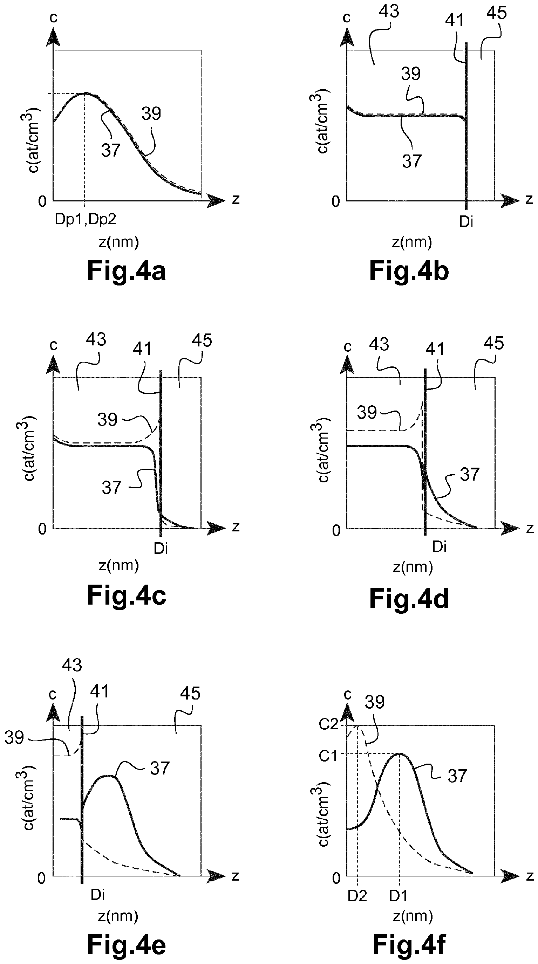

Figure 4a depicts a graph of the dopant concentration profiles 37, 39 in semiconductor material 3 after steps b) and c).

In this Figure 4a, the first dose of first dopants 7 and the second dose of second dopants 9 are equal. Alternatively, the first dose of first dopants 7 and the second dose of second dopants 9 may be different.

Both dopant concentration profiles 37, 39 show a concentration peak at a depth corresponding to the respective projection depths Dp1, Dp2. Since the first projection depth Dp1 and the second projection Dp2 are, here, equal, then the first dopant concentration profile 37 and the second dopant concentration profile 39 are sensibly similar. Furthermore, the concentration of first dopants C1 at the first concentration peak is, here, equal to the concentration of second dopants C2 at the second concentration peak.

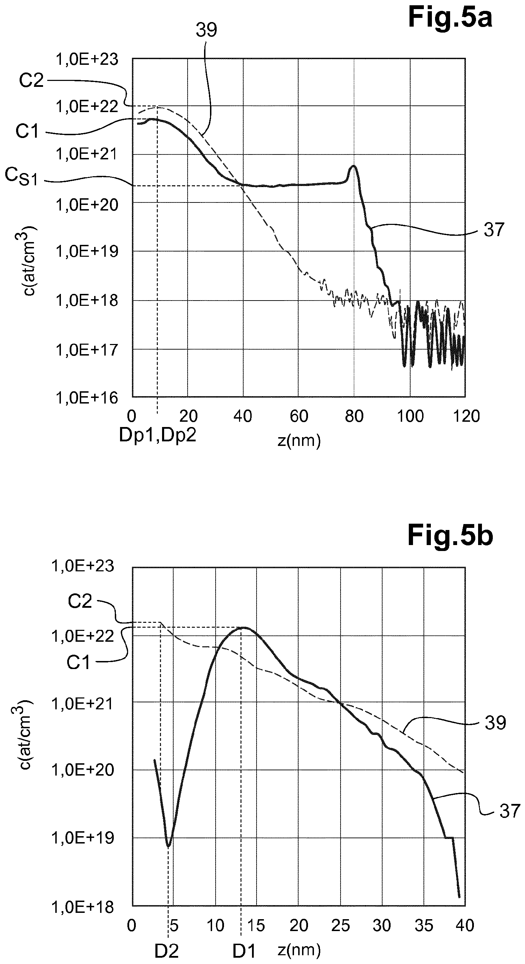

Figure 5a represents a test result of the implantation steps b) and c) of Boron and Gallium atoms into a material of $Si_{x-1}Ge_x$, where x is equal, for example to 0.7. The data were measured by Secondary Ion Mass Spectroscopy (SIMS). Due to a presence of native oxide near the surface of semiconductor material, the signal of SIMS acquired from a layer of initial thickness 2 nm of semiconductor material is incorrect and is removed from the graph of Figure 5a. The semiconductor material is sensibly 80 nm thick.

In this Figure 5a, the first dose of first dopants 7 and the second dose of second dopants 9 are equal and comprised between $1x10^{21}$ atoms/cm$^3$ and $1x10^{23}$ atoms/cm$^3$ (at/cm$^3$).

The experimental results show that first dopant concentration profile 37 and second dopant concentration profile 39 are sensibly similar after steps b) and c) in implanted region 13, here from 2 nm to 40nm. Both dopant concentration profiles 37, 39 show a concentration peak at a depth of 10 nm corresponding to the respective projection depths Dp1, Dp2 of each dopants 7, 9. The concentration of first dopants C1 at the first concentration peak is lower than $1x10^{22}$ atoms/cm$^3$. The concentration of second dopants C2 at the second concentration peak is sensibly equal to $1x10^{22}$ atoms/cm$^3$.

The concentration of first dopants C1 then decreases to a step concentration Cs1 at a depth of 40nm and remains sensibly stable throughout the thickness of the semiconductor material from a depth of 40 nm to 80nm. This phenomenon is due to a pre-doping of another dose of first dopants 7 into the semiconductor material during an epi-growth of the semiconductor material.

The concentration of second dopants C2 decreases throughout the semiconductor material 3.

During a step d), nanosecond pulsed laser beam 23 melts implanted region 13 of semiconductor material 3 to diffuse the first dose of first dopants 7 and the second dose of second dopants 9 into implanted region 13.

The nanosecond pulsed laser beam 23 could melt semiconductor material 3 to a molten Depth Dm extending only to implanted region 13, however in this example; the molten region 25 (refer back to Figure 1) is larger than implanted region 13. Thereby, first dopants 7 and second dopants 9 diffuse into a molten region 25 larger than implanted region 13.

Figure 4b represents the dopant concentration profiles 37, 39 in semiconductor material 3 during melting. A vertical line at an interface depth Di represents a liquid/solid interface 41 in semiconductor material 3. An area at shallower depths than interface depth Di represents a liquid phase region of semiconductor material 3. An area at greater depths than interface depth Di represents a solid phase region 45 of semiconductor material 3.

On the graph of Figure 4b, it is visible that first dopants 7 and second dopants 9 are sensibly uniformly distributed in the molten region of the semiconductor material 3.

During a step e) the molten implanted region is crystallized to form doped region 27.

Figures 4c to 4e illustrate a plurality of stages of the crystallization of molten implanted region 25. During the crystallization, molten implanted region 25 crystallizes bit by bit, starting at the deepest end. During the crystallization liquid/solid interface 41 moves towards the surface of semiconductor material 3 at a velocity v. The segregation coefficient k depends on the velocity of liquid/solid interface 41. To benefit from the segregation effect, velocity v of liquid/solid interface 41 should remains below a predetermined velocity threshold vt. If velocity v is above the predetermined velocity threshold vt, then the dopants 7, 9 do not have enough time to migrate towards the liquid phase 43 and/or the solid phase 45, and the segregation effect is much less pronounced. In other words, if molten region 25 crystallizes too fast, then the segregation effect is much less pronounced and even not observed in some cases.

As a consequence, beam control device 21 controls velocity v of liquid/solid interface 41 during step e) by controlling the molten depth Dm and the temperature of molten region 25.

Here, to control velocity v of liquid/solid interface 41, beam control device 21 adjusts some of the previously mentioned parameters relative to nanosecond pulsed laser beam 23, i.e. the pulse shape, pulse duration, and pulse energy density of nanosecond pulsed laser beam 23.

Figure 6 is graph of the variation of the velocity v of the liquid/solid interface 41 as a function of molten depth Dm in semiconductor material 3. The graph of Figure 6 was obtained with a simulation software. The graph of Figure 6 represents an estimation of results that may be achieved with the method, based on the capacities of beam control device 21 (adjustment of the previously mentioned parameters relative to nanosecond pulsed laser beam 23) and on the experimental displayed on Figures 5a and 5b.

A first curve 47 represents the variation of velocity v of liquid/solid interface 41 in a crystallizing pure Si semiconductor material. A second curve 49 represents the variation of velocity v of liquid/solid interface 41 in a crystallizing pure Ge semiconductor material. The variation of velocity v of liquid/solid interface 41 in a crystallizing SiGe semiconductor material should be sensibly similar to the velocity v of liquid/solid interface 41 in Si and in Ge.

For both curves 47, 49, it is visible that as molten depth Dm decreases, the velocity v of the liquid/solid interface 41 decreases.

A velocity threshold vt is for example 2m/s.

In the experimental test results of Figures 5a and 5b, the molten depth Dm is approximately 22 nm for a SiGe semiconductor material, hence the velocity v of the liquid/solid interface 41 is below the velocity threshold of 2 m/s.

The velocity v of the liquid/solid interface is, for example, comprised between 0.3 m/s and 2 m/s. The velocity v of the liquid/solid interface is, for example, 1 m/s.

On graphs 4c to 4e, it is clearly visible that second dopants 9 (with a lower second segregation coefficient k2 than first segregation coefficient k1) tend to migrate in the liquid phase region 43. That is why, during the crystallization, the concentration of second dopants is maximum in the liquid phase region 43 near liquid/solid interface 41. The concentration of second dopants 9 increases in the liquid phase region 43 as the latter decreases in size.

First dopants 7 (with a first segregation coefficient k1 greater than second segregation coefficient k2) have a lower segregation effect than second dopants 9. First dopants 7 tend to distribute more uniformly than second dopants 9, into the liquid phase region 43 and the solid phase region 45 of semiconductor material 3, as illustrated on Figures 4c) to 4e).

The doping profile of the formed doped region is illustrated by Figure 4f. On this graph, the two concentration peaks are clearly visible and distinct.

The second concentration peak of second dopants 9 is formed at second depth D2. Second depth D2 is, here, near the surface of semiconductor device 3.

The first concentration peak of first dopants 7 is formed at first depth D1 greater than the second depth D2.

As first dopants 7 are distributed over a larger region than second dopants 9, the concentration of first dopants C1 at the first concentration peak is lower than the concentration of second dopants C2 at the second concentration peak. In other words, first dopant profile 37 is lower and broader than second dopant profile 39.

Figure 5b illustrates test results of doped region 27 obtained with the method of the invention.

The contribution of the semiconductor material doped during the epi-grown step has been removed.

First dopant concentration profile 37 clearly shows the first peak at first depth D1 about 13 nm.

Second dopant concentration profile 39 decreases from the shallower measurement point to the deepest measurement point.

The concentration of first dopants C1 at the first concentration peak is comprised between $1 \times 10^{21}$ atoms/cm$^3$ and $1 \times 10^{23}$ atoms/cm$^3$. The concentration of second dopants C2 at second concentration peak is comprised between $1 \times 10^{21}$ atoms/cm$^3$ and $1 \times 10^{23}$ at-

oms/cm$^3$.

The test confirms that, since second dopants 9 are distributed over a smaller area than first dopants 7, the concentration of second dopants C2 at the second concentration peak is greater than the concentration of first dopants C1 at first concentration peak.

Here, the concentration peaks of both doping profiles 37, 39 in the crystallized region are higher than $1 \times 10^{22}$ atoms/cm$^3$. The concentration peaks of both doping profiles 37, 39 after crystallization are greater than the peak dopant concentration after implantation (Figure 5a).

The spike at 2nm depth of second dopant concentration profile 39 is due to measurement error (effect of surface native oxide).

According to another example of the method, at least a third dopant having a third segregation coefficient, different from first segregation coefficient k1 and second segregation coefficient k2, is selected during step a). For example, third segregation coefficient is smaller than both first and second segregation coefficients k1, k2.

A third dose of third dopants is then implanted at a third projection depth before step d). The third dose may be equal to or different from the first dose of first dopants and the second dose of second dopants. The third projection depth may be equal to first projection depth and/or to second projection depth. Alternatively, third projection depth may be different from first projection depth and from second projection depth.

During step d), the third dopant diffuses in the molten region and migrates according to the third segregation coefficient.

During step e) the molten region crystallizes and a third concentration peak of third dopant is formed at a third semiconductor material depth. The third semiconductor material depth depends on the third segregation coefficient. According to this example, as third segregation coefficient is smaller than both first and second segregation coefficients, then third semiconductor material depth is shallower than first and second semiconductor material depths.

Thanks to this third dopant concentration peak, the resistance within the doped region of semiconductor material 3 is decreased, and its electrical performances improve.

## Claims

1. Method for forming a doped region (27) in a semiconductor material (3), comprising steps of:

   b) implanting a first dose of a first dopants (7) to form an implanted region (13) of the semiconductor material (3),

      - implanting a second dose of a second dopants (9) to said implanted region (13),

   c) melting the implanted region (13) with a nanosecond pulsed laser beam (23) to diffuse the first dose of first dopants (7) and the second dose of second dopants (9) into a molten implanted region (25),
   - d) crystallizing the molten implanted region (25) to form said doped region (27), said doped region (27) having a first dopant concentration profile (37) with a first concentration peak at a first semiconductor material depth (D1), and a second dopant concentration profile (39) with a second concentration peak at a second semiconductor material depth (D2), wherein the first material depth (D1) is greater than the second semiconductor material depth (D2).

2. Method according to claim 1, wherein the first dopants (7) have a first segregation coefficient (k1) and the second dopants (9) have a second segregation coefficient (k2) and wherein the method further comprises a step a) of selecting the first dopants (7) and the second dopants (9) according to their respective segregation coefficients (k1, k2).

3. Method according to claim 1 or 2, wherein the second segregation coefficient (k2) is lower than the first segregation coefficient (k1).

4. Method according to any of the claims 1 to 3, wherein during step d) of crystallizing, a liquid/solid interface (41) between a liquid phase (43) of the semiconductor material (3) and a solid phase (45) of the semiconductor substrate (3) moves towards a surface of the semiconductor material (3) at a velocity (v), said velocity (v) of the liquid/solid interface (41) being controlled by a parameter relative to the nanosecond pulsed laser beam (23).

5. Method according to claim 4, wherein the parameter relative to the nanosecond pulsed laser beam (23) includes at least one among: a pulse shape, a pulse duration, a pulse energy density.

6. Method according to any of the claims 1 to 5, wherein the first dopants (7) are implanted to extend to a first projection depth (Dp1) and the second dopants are implanted to extend to a second projection depth (Dp2) and wherein the first projection depth (Dp1) and the second projection depth (Dp2) are sensibly equal.

7. Method according to any of the claims 1 to 6, further comprising a step of providing at least a third dose of a third dopants to the implanted region, the third dopants having a third segregation coefficient different from the first segregation coefficient and the second segregation coefficient.

8. Semiconductor material having a doped region (27) comprising a first dopants (7) having a first dopant concentration profile (37) with a first concentration peak at a first semiconductor material depth (D1), and a second dopants (9) having a second dopant concentration profile (39) with a second concentration peak at a second semiconductor material depth (D2), wherein the first semiconductor material depth (D1) is greater than the second semiconductor material depth (D2).

9. Semiconductor material (3) according to claim 8, wherein a concentration of first dopants (C1) at the first concentration peak is comprised between $1 \times 10^{21}$ atoms/cm$^3$ and $1 \times 10^{23}$ atoms/cm$^3$.

10. Semiconductor material (3) according to any of claims 8 or 9, wherein a concentration of second dopants (C2) at the second concentration peak is comprised between $1 \times 10^{21}$ atoms/cm$^3$ and $1 \times 10^{23}$ atoms/cm$^3$.

11. Semiconductor material (3) according to any of claims 8 to 10, wherein the second semiconductor material depth (D2) is comprised between 0 and 10 nm, and the first semiconductor material depth (D1) is greater than the second semiconductor material depth (D2).

12. Semiconductor material (3) according to any of claims 8 to 11, wherein the first dopants (7) have a first segregation coefficient (k1) and the second dopants (9) have a second segregation coefficient (k2) different from said first segregation coefficient (k1).

13. Semiconductor material according to any of claims 8 to 12, further comprising a third dopant having a third dopant concentration profile with a third concentration peak at a third semiconductor material depth, wherein the third semiconductor material depth is different from the first semiconductor material depth and from the second semiconductor material depth.

14. Semiconductor device (31) comprising a semiconductor material (3) of any of claims 8 to 13, having a metallic contact region (33) situated on a surface of the doped region (27) of the semiconductor material (3).

Fig.1

Fig.2

Fig.3

Fig.4a

Fig.4b

Fig.4c

Fig.4d

Fig.4e

Fig.4f

## Fig.5a

## Fig.5b

Europäisches
Patentamt

European
Patent Office

Office européen
des brevets

# EUROPEAN SEARCH REPORT

**Application Number**

EP 18 18 9418

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 364 778 A (LEAMY HARRY J ET AL) 21 December 1982 (1982-12-21) | 1-10, 12-14 | INV. H01L21/265 H01L21/268 |
| Y | * the whole document * | 11 | |
| Y | US 2008/006887 A1 (UENO TETSUJI [KR] ET AL) 10 January 2008 (2008-01-10) * paragraph [0018] * | 11 | |
| X | US 2009/227097 A1 (BATEMAN NICHOLAS [US] ET AL) 10 September 2009 (2009-09-10) * figure 1C * | 8 | |
| X | WO 2007/103643 A2 (APPLIED MATERIALS INC [US]; MAYUR ABHILASH [US]; YAM MARK [US]; BALAKR) 13 September 2007 (2007-09-13) * figure 3B * | 8 | |
| A | US 5 565 377 A (WEINER KURT H [US] ET AL) 15 October 1996 (1996-10-15) * column 2, line 14 - line 20 * | 4 | |

| | | | TECHNICAL FIELDS SEARCHED (IPC) |
|---|---|---|---|
| | | | H01L |

The present search report has been drawn up for all claims

| Place of search | Date of completion of the search | Examiner |
|---|---|---|
| The Hague | 18 January 2019 | Gélébart, Jacques |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 18 9418

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2019

| Patent document cited in search report | | Publication date | Patent family member(s) | | | Publication date |
|---|---|---|---|---|---|---|
| US 4364778 | A | 21-12-1982 | NONE | | | |
| US 2008006887 | A1 | 10-01-2008 | CN | 101026091 | A | 29-08-2007 |
| | | | DE | 102007005332 | A1 | 06-09-2007 |
| | | | JP | 2007208264 | A | 16-08-2007 |
| | | | KR | 100732630 | B1 | 20-06-2007 |
| | | | TW | 200731361 | A | 16-08-2007 |
| | | | US | 2008006887 | A1 | 10-01-2008 |
| US 2009227097 | A1 | 10-09-2009 | TW | 200950122 | A | 01-12-2009 |
| | | | US | 2009227097 | A1 | 10-09-2009 |
| | | | US | 2014154834 | A1 | 05-06-2014 |
| | | | WO | 2009111668 | A2 | 11-09-2009 |
| WO 2007103643 | A2 | 13-09-2007 | EP | 1992013 | A2 | 19-11-2008 |
| | | | JP | 5558006 | B2 | 23-07-2014 |
| | | | JP | 2009529245 | A | 13-08-2009 |
| | | | KR | 20080104183 | A | 01-12-2008 |
| | | | KR | 20100133454 | A | 21-12-2010 |
| | | | WO | 2007103643 | A2 | 13-09-2007 |
| US 5565377 | A | 15-10-1996 | NONE | | | |

EPO FORM P0459

For more details about this annex : see Official Journal of the European Patent Office, No. 12/82